# EUROPEAN PATENT APPLICATION

(11) **EP 1 434 474 A2**
(43) Date of publication of application: **30.06.2004**
(21) Application number: 03394086.7
(22) Date of filing: 12.09.2003
(51) Int. Cl.: H05K 1/11, H05K 3/46, H01L 23/498

(54) **Technique for electrically interconnecting electrical signals between an electronic component and a multilayer signal routing device**

(30) Priority: 23.12.2002 US 326079
(71) Applicant: Nortel Networks Limited, St. Laurent, Quebec H4S 2A9 (CA)
(72) Inventor: Duxbury, Guy, Nepean, ON K2H 6K3 (CA); Kwong, Herman, Kanata, ON K2L 3S2 (CA); Wyrczykowska, Aneta, Kanata, ON K2L 3N2 (CA); Difilippo, Luigi G., Kanata, ON K2T 1C7 (CA)
(74) Representative: Coyle, Philip Aidan

(57) **Abstract**

A technique for electrically interconnecting electrical signals between an electronic component and a multilayer signal routing device is disclosed. In one particular exemplary embodiment, the technique may be realized as an interconnect array for electrically interconnecting electrical signals between an electronic component and a multilayer signal routing device having a plurality of electrically conductive signal path layers. In such a case, the interconnect array comprises a plurality of electrically conductive contacts grouped into a plurality of arrangements of electrically conductive contacts, wherein each of the plurality of arrangements of electrically conductive contacts are separated from other adjacent ones of the plurality of arrangements of electrically conductive contacts by a channel that is correspondingly formed in the multilayer signal routing device such that an increased number of electrical signals may be routed therein on the plurality of electrically conductive signal path layers.

## Description

### CROSS-REFERENCE TO RELATED APPLICATIONS

This patent application is a continuation-in-part patent application of U.S. Patent Application No. 10/126,700 (Attorney Docket No. 57983-000085, Client Reference No. 12623ROUS03C), filed April 22, 2002, which is a continuation patent application of U.S. Patent Application No. 09/651,188 (Attorney Docket No. 57983-000010, Client Reference No. 12623ROUS02U), filed August 30, 2000, now U.S. Patent No. 6,388,890, which claims priority to U.S. Provisional Patent Application No. 60/212,387, filed June 19, 2000, all of which are hereby incorporated by reference herein in their entirety.

This patent application is also a continuation-in-part patent application of U.S. Patent Application No. 10/101,211 (Attorney Docket No. 57983-000076, Client Reference No. 14918ROUS01U), filed March 20, 2002, which is a continuation-in-part patent application of U.S. Patent Application No. 09/651,188 (Attorney Docket No. 57983-000010, Client Reference No. 12623ROUS02U), filed August 30, 2000, now U.S. Patent No. 6,388,890, which claims priority to U.S. Provisional Patent Application No. 60/212,387, filed June 19, 2000, all of which are hereby incorporated by reference herein in their entirety.

### FIELD OF THE INVENTION

The present invention relates generally to multilayer signal routing devices and, more particularly, to a technique for electrically interconnecting electrical signals between an electronic component and a multilayer signal routing device.

### BACKGROUND OF THE INVENTION

The making of electrical connections between electronic components has long been accomplished using printed circuit boards. The first such circuit boards had only a single signal layer on a top surface thereof for routing electrical signals between electronic components mounted thereon. These single signal layer circuit boards have severe limitations with regard to the number of electrical signals that can be routed between electronic components mounted on the same circuit board. That is, the number of electrical signals that can be routed between electronic components mounted on a single signal layer circuit board is limited by the amount of area on the single signal layer.

The area limitations associated with single signal layer circuit boards led to the development of multilayer printed circuit boards. Such multilayer printed circuit boards may be either single or double-sided and may have multiple signal layers on the surface of and buried within the multilayer printed circuit boards. Thus, such multilayer printed circuit boards have allowed a large increase in the number of electrical signals that may be routed between electronic components mounted on the same circuit board.

The use of multilayer printed circuit boards has been particularly beneficial when using electronic components having high density packages. That is, electronic components having high density packages generally require multiple layers of a multilayer printed circuit board to make electrical connections with other electronic components mounted on the same circuit board. In fact, the density of electronic component packages typically dictates the number of layers that must be provided by the multilayer printed circuit board upon which the electronic component is mounted. While the number of layers that may be provided by a multilayer printed circuit board is theoretically unlimited, problems occur when the number of layers in a multilayer printed circuit board exceeds a reasonable number, particularly when trying to route high speed electrical signals between electronic components. For example, when making electrical connections between different layers in multilayer printed circuit boards, electrically conductive vias are generally used. While these electrically conductive vias allow direct vertical electrical connections to be made between different layers within a multilayer printed circuit board, there are intrinsic parasitics associated with these electrically conductive vias that can adversely affect the performance of signals propagating therethrough. That is, these electrically conductive vias have intrinsic parasitic resistance, capacitance, and inductance, which can adversely affect signals propagating along each electrically conductive via. In addition, these intrinsic parasitics can also have an adverse effect on the manufacturability of a printed circuit board and thus the cost thereof. Because of their adverse affect on signal performance, these intrinsic parasitics can also limit the bandwidth of signals propagating along each electrically conductive via. These adverse affects only increase as the number of layers in a multilayer printed circuit board increase.

In view of the foregoing, it would be desirable to provide a technique for increasing the number of electrical connections that may be made between electronic components mounted on a multilayer printed circuit board without increasing the number of layers in the multilayer printed circuit board. More particularly, it would be desirable to provide a technique for reducing the number of layers in a multilayer signal routing device in an efficient and cost effective manner.

### SUMMARY OF THE INVENTION

According to the present invention, a technique for electrically interconnecting electrical signals between an electronic component and a multilayer signal routing device is provided. In one particular exemplary embodiment, the technique may be realized as an interconnect array for electrically interconnecting electrical signals between an electronic component and a multilayer signal routing device having a plurality of electrically conductive signal path layers. In such a case, the interconnect array comprises a plurality of electrically conductive contacts grouped into a plurality of arrangements of electrically conductive contacts, wherein each of the plurality of arrangements of electrically conductive contacts are separated from other adjacent ones of the plurality of arrangements of electrically conductive contacts by a channel that is correspondingly formed in the multilayer signal routing device such that an increased number of electrical signals may be routed therein on the plurality of electrically conductive signal path layers.

In accordance with other aspects of this particular exemplary embodiment of the present invention, each of the plurality of arrangements of electrically conductive contacts may beneficially have any number of shapes and sizes.

In accordance with further aspects of this particular exemplary embodiment of the present invention, the channel may beneficially be formed by removing electrically conductive contacts from a non-channelized interconnect array. If such is the case, the electrically conductive contacts that are removed from the non-channelized interconnect array may beneficially comprise at least one of a row of electrically conductive contacts and a column of electrically conductive contacts.

In accordance with still further aspects of this particular exemplary embodiment of the present invention, the plurality of electrically conductive contacts that are grouped into the plurality of arrangements of electrically conductive contacts beneficially have a substantial center and at least one substantial edge, and the channel beneficially expands in width while traversing from the substantial center to the at least one substantial edge.

In accordance with additional aspects of this particular exemplary embodiment of the present invention, all of the plurality of arrangements of electrically conductive contacts may beneficially be associated with a single electronic component. Alternatively, at least one of the plurality of arrangements of electrically conductive contacts may beneficially be associated with a separate electronic component.

In accordance with still additional aspects of this particular exemplary embodiment of the present invention, each of the plurality of electrically conductive contacts may beneficially have an associated electrical property, and at least some of the plurality of electrically conductive contacts may beneficially be physically arranged based at least in part upon their associated electrical properties such that the channel is formed in accordance with the arrangement. For example, the electrical property associated with each of the plurality of electrically conductive contacts may beneficially comprise a signal electrical property, a power electrical property, a ground electrical property, a test electrical property, or a no-connect electrical property.

In accordance with still other aspects of this particular exemplary embodiment of the present invention, the channel may beneficially coincide with selected ones of the plurality of electrically conductive contacts. Also, the channel that is correspondingly formed in the multilayer signal routing device may beneficially be formed on at least one of the plurality of electrically conductive signal path layers beneath selected ones of the plurality of electrically conductive contacts.

In another particular exemplary embodiment, the technique may be realized as a method for electrically interconnecting electrical signals between an electronic component and a multilayer signal routing device having a plurality of electrically conductive signal path layers. In such a case, the method comprises identifying a plurality of electrical signals to be routed, and arranging a plurality of electrically conductive contacts each associated with respective ones of the plurality of electrical signals into a plurality of arrangements of electrically conductive contacts, wherein each of the plurality of arrangements of electrically conductive contacts are separated from other adjacent ones of the plurality of arrangements of electrically conductive contacts by a channel that is correspondingly formed in the multilayer signal routing device such that an increased number of the plurality of electrical signals may be routed therein on the plurality of electrically conductive signal path layers. The method may comprise additional features along the lines of those recited above with respect to the above-described interconnect array.

The present invention will now be described in more detail with reference to exemplary embodiments thereof as shown in the appended drawings. While the present invention is described below with reference to preferred embodiments, it should be understood that the present invention is not limited thereto. Those of ordinary skill in the art having access to the teachings herein will recognize additional implementations, modifications, and embodiments, as well as other fields of use, which are within the scope of the present invention as disclosed and claimed herein, and with respect to which the present invention could be of significant utility.

### BRIEF DESCRIPTION OF THE DRAWINGS

In order to facilitate a more full understanding of the present invention, reference is now made to the appended drawings. These drawings should not be construed as limiting the present invention, but are intended to be exemplary only.

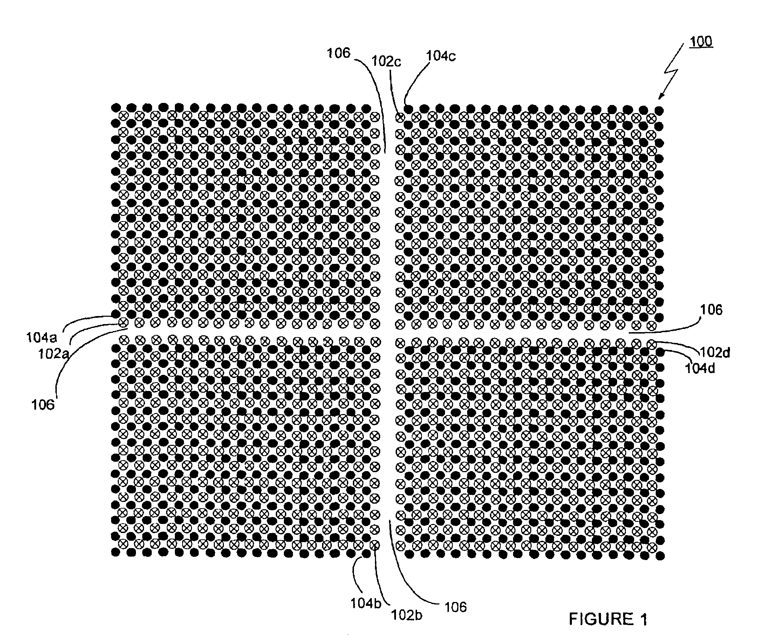

Figure 1 shows a portion of a surface layer of a multilayer signal routing device having an array of electrically conductive contacts and a corresponding array of electrically conductive contacts/vias.

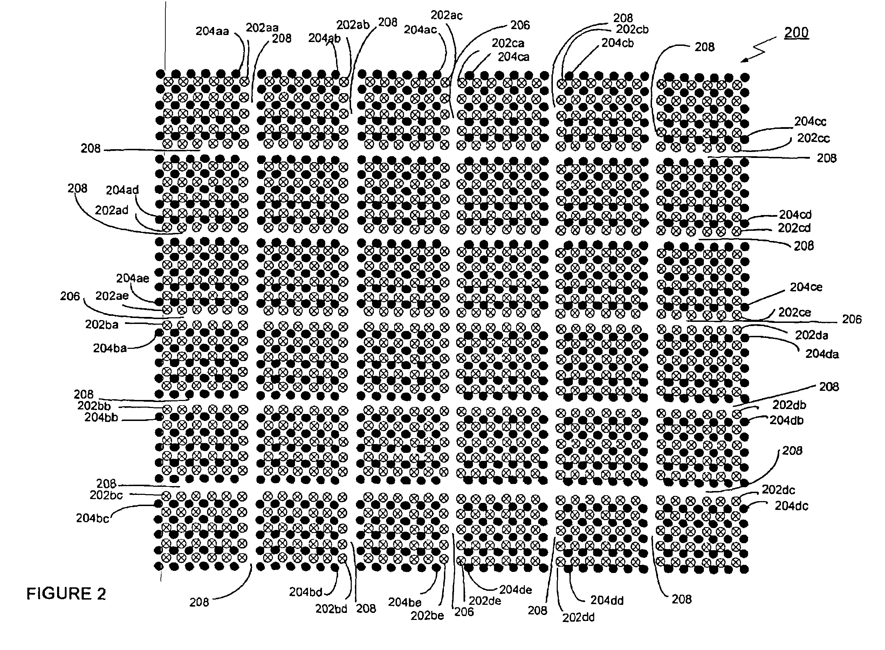

Figure 2 shows a portion of a surface layer of a multilayer signal routing device having an array of electrically conductive contacts and a corresponding array of electrically conductive contacts/vias in accordance with an embodiment of the present invention.

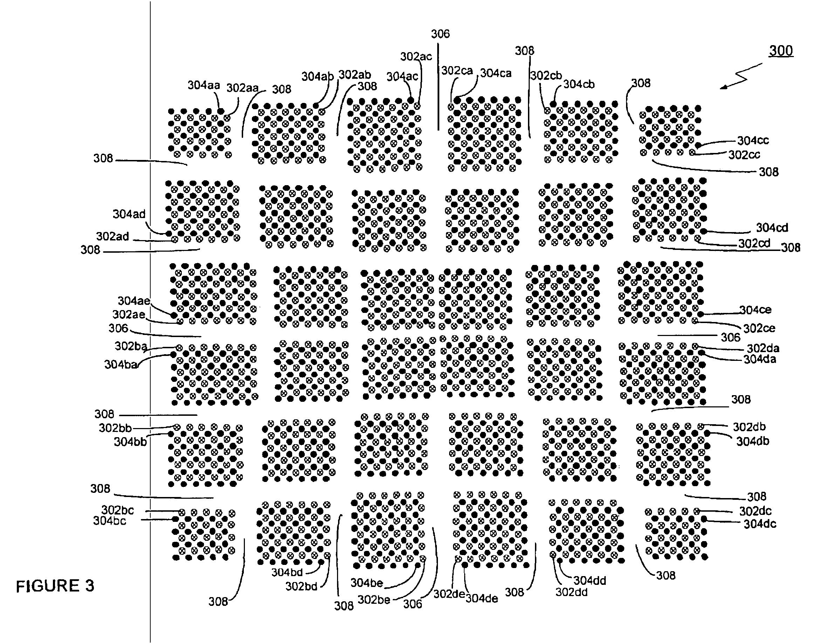

Figure 3 shows a portion of a surface layer of a multilayer signal routing device having an alternate embodiment of an array of electrically conductive contacts and a corresponding array of electrically conductive contacts/vias in accordance with an embodiment of the present invention.

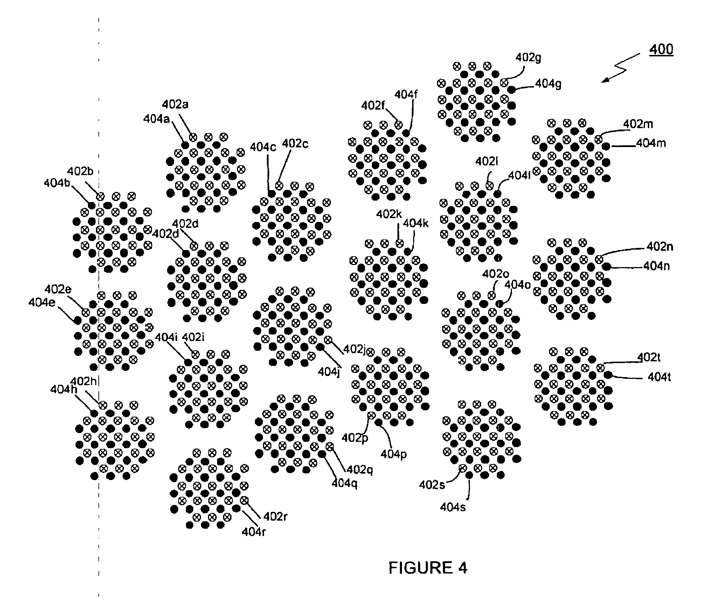

Figure 4 shows a portion of a surface layer of a multilayer signal routing device having another alternate embodiment of an array of electrically conductive contacts and a corresponding array of electrically conductive contacts/vias in accordance with an embodiment of the present invention.

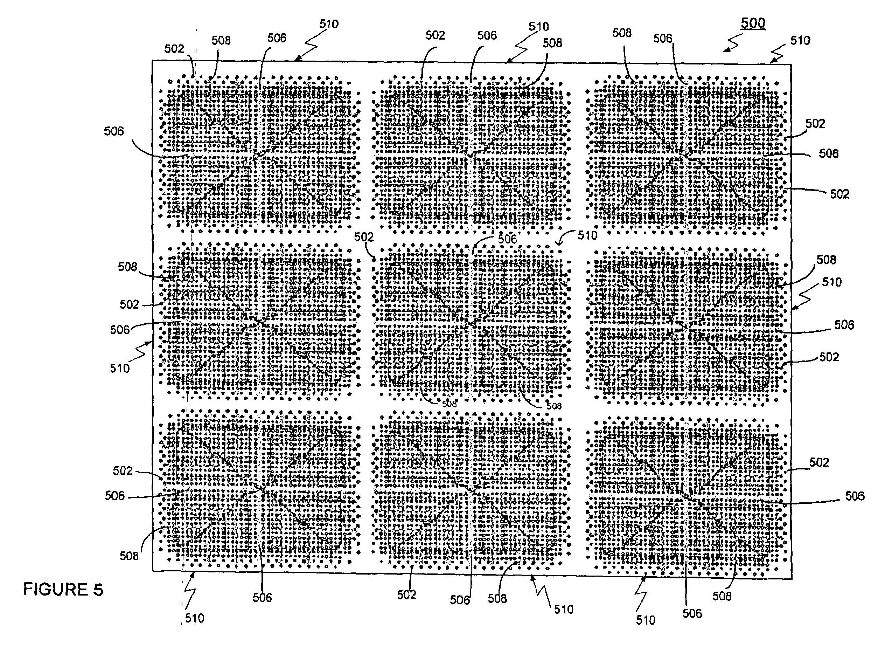

Figure 5 shows a portion of a surface layer of a multilayer signal routing device having nine subarrays of electrically conductive contacts for mating with nine corresponding subarrays of electrically conductive contacts of a surface mount grid array package of an electronic component that is mounted on the surface of the multilayer signal routing device in accordance with an embodiment of the present invention.

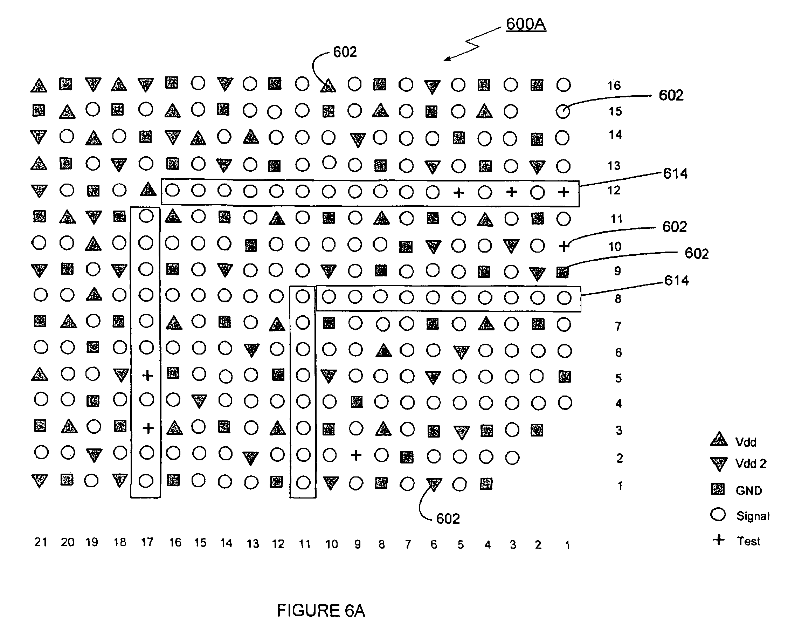

Figure 6A shows a portion of a surface layer of a multilayer signal routing device having 330 electrically conductive contacts for mating with 330 corresponding electrically conductive contacts of a quadrant of a surface mount grid array package of an electronic component having a total of 1247 electrically conductive contacts that is mounted on the surface of the multilayer signal routing device in accordance with an embodiment of the present invention.

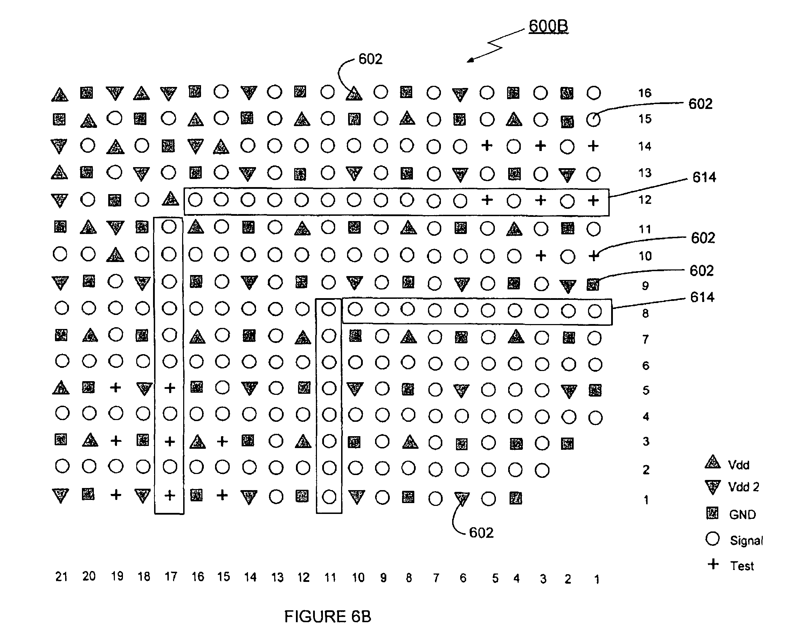

Figure 6B shows a portion of a surface layer of a multilayer signal routing device having 330 electrically conductive contacts for mating with 330 corresponding electrically conductive contacts of a quadrant of a surface mount grid array package of an electronic component having a total of 1247 electrically conductive contacts that is mounted on the surface of the multilayer signal routing device in accordance with an embodiment of the present invention.

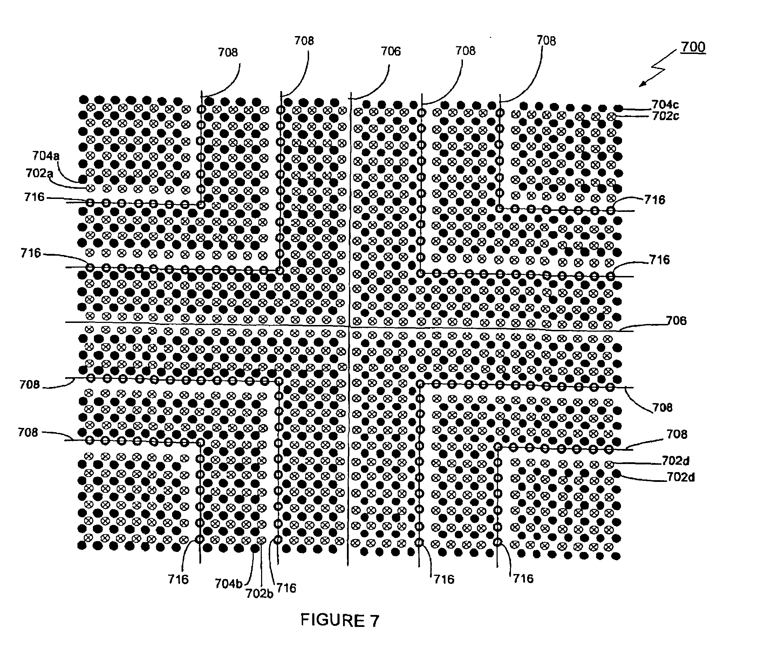

Figure 7 shows a portion of a surface layer of a multilayer signal routing device having 952 electrically conductive contacts for mating with 952 corresponding electrically conductive contacts of a surface mount grid array package of an electronic component that is mounted on the surface of the multilayer signal routing device in accordance with an embodiment of the present invention.

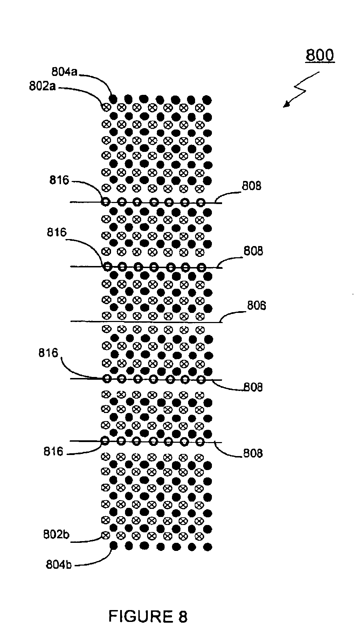

Figure 8 shows a portion of a surface layer of a multilayer signal routing device having 196 electrically conductive contacts for mating with 196 corresponding electrically conductive contacts of a surface mount grid array package of an electronic connector component that is mounted on the surface of the multilayer signal routing device in accordance with an embodiment of the present invention.

### DETAILED DESCRIPTION OF EXEMPLARY EMBODIMENT(S)

At the outset, it is helpful to refer to the microvia-based techniques for reducing the number of layers in a multilayer signal routing device as have been substantially described in the above-referenced U.S. Patent Application No. 10/126,700, U.S. Patent Application No. 09/651,188 (now U.S. Patent No. 6,388,890), and U.S. Provisional Patent Application No. 60/212,387, all of which have been incorporated by reference herein in their entirety. It is also helpful to refer to the power/ground-based techniques for reducing the number of layers in a multilayer signal routing device as have been substantially described in the above-referenced U.S. Patent Application No. 10/101,211, U.S. Patent Application No. 09/651,188 (now U.S. Patent No. 6,388,890), and U.S. Provisional Patent Application No. 60/212,387, all of which have been incorporated by reference herein in their entirety.

The above-referenced microvia-based and power/ground-based techniques are certainly beneficial for reducing the number of layers in a multilayer signal routing device. However, these techniques may be even more beneficial if an electronic component that is mounted on the multilayer signal routing device is designed with signal routing in mind. For example, referring to Figure 1, there is shown a portion 100 of a surface layer of a multilayer signal routing device having 952 (i.e., a 28 x 34 array) electrically conductive contacts 102 for mating with 952 (i.e. , also a 28 x 34 array) corresponding electrically conductive contacts of a surface mount grid array package of an electronic component that is mounted on the surface of the multilayer signal routing device. Of course, it is within the scope of the present invention that the 952 electrically conductive contacts 102 may mate with 952 corresponding electrically conductive contacts of multiple surface mount grid array packages of multiple electronic components (or multichip modules or hybrid modules having multiple electronic components of like or differing kind) that are mounted on the surface of the multilayer signal routing device.

Figure 1 also shows an electrically conductive contact/via 104 that is electrically connected to each of the electrically conductive contacts 102 on the surface layer of the multilayer signal routing device via a dog-bone configuration. The electrical connections between each of the electrically conductive contacts 102 and each respective electrically conductive contact/via 104 are not shown in Figure 1 for purposes of figure clarity. However, the letter designations associated with each numerical reference designator indicate which electrically conductive contact 102 is electrically connected to which respective electrically conductive contact/via 104. As can be derived from these letter designations, the array of electrically conductive contacts 102, or, more appropriately, the array of electrically conductive contacts/vias 104, may be divided into four quadrants (e.g., the a, b, c, & d quadrants). The four quadrants are separated via the dog-bone configuration by center channels 106, which are formed in the array of electrically conductive contacts 102, or, more appropriately, the array of electrically conductive contacts/vias 104, so as to allow electrical signals to be routed within these center channels 106 in one or more electrically conductive signal path layers of the multilayer signal routing device beneath corresponding ones of the electrically conductive contacts 102.

Unfortunately, unless the electrically conductive contacts of the surface mount grid array package of the electronic component that is mounted on the surface of the multilayer signal routing device is designed with signal routing in mind, further channels cannot be formed in the one or more electrically conductive signal path layers of the multilayer signal routing device without using the above-referenced microvia-based and power/ground-based techniques. For example, referring to Figure 2, there is shown a portion 200 of a surface layer of a multilayer signal routing device having 1080 (i.e., a 30 x 36 array) electrically conductive contacts 202 for mating with 1080 (i.e., also a 30 x 36 array) corresponding electrically conductive contacts of a surface mount grid array package of an electronic component that is mounted on the surface of the multilayer signal routing device. Of course, it is within the scope of the present invention that the 1080 electrically conductive contacts 202 may mate with 1080 corresponding electrically conductive contacts of multiple surface mount grid array packages of multiple electronic components (or multichip modules or hybrid modules having multiple electronic components of like or differing kind) that are mounted on the surface of the multilayer signal routing device.

Figure 2 also shows an electrically conductive contact/via 204 that is electrically connected to each of the electrically conductive contacts 202 on the surface layer of the multilayer signal routing device via a dog-bone configuration. As with Figure 1, the electrical connections between each of the electrically conductive contacts 202 and each respective electrically conductive contact/via 204 are not shown in Figure 2 for purposes of figure clarity. However, the letter designations associated with each numerical reference designator indicate which electrically conductive contact 202 is electrically connected to which respective electrically conductive contact/via 204. As can be derived from these letter designations, the array of electrically conductive contacts 202, or, more appropriately, the array of electrically conductive contacts/vias 204, may be divided into four main quadrants (e.g., the a, b, c, & d main quadrants). The four main quadrants are separated via the dog-bone configuration by center channels 206, which are formed in the array of electrically conductive contacts 202, or, more appropriately, the array of electrically conductive contacts/vias 204, so as to allow electrical signals to be routed within these center channels 206 in one or more electrically conductive signal path layers of the multilayer signal routing device beneath corresponding ones of the electrically conductive contacts 202. Additional channels 208 are formed in each of the four main quadrants by eliminating rows and columns of electrically conductive contacts 202 in the array of electrically conductive contacts 202, and hence in the array of electrically conductive contacts/vias 204, so as to allow electrical signals to be routed within these additional channels 208 in one or more electrically conductive signal path layers of the multilayer signal routing device beneath corresponding ones of the electrically conductive contacts 202. Of course, in order to eliminate rows and columns of electrically conductive contacts 202 in the array of electrically conductive contacts 202, and hence in the array of electrically conductive contacts/vias 204, corresponding rows and columns of electrically conductive contacts must be removed from the surface mount grid array package of the electronic component that is mounted on the surface of the multilayer signal routing device. Thus, one aspect of the present invention is to remove rows and columns of electrically conductive contacts from the surface mount grid array package of the electronic component that is mounted on the surface of the multilayer signal routing device so as to allow corresponding rows and columns of electrically conductive contacts 202 to be removed from the array of electrically conductive contacts 202, and hence the array of electrically conductive contacts/vias 204, thereby allowing additional channels 208 to be formed in the array of electrically conductive contacts 202, or, more appropriately, the array of electrically conductive contacts/vias 204, so as to allow electrical signals to be routed within these additional channels 208 in one or more electrically conductive signal path layers of the multilayer signal routing device beneath corresponding ones of the electrically conductive contacts 202.

Referring to Figure 3, there is shown an expansion of the concept shown in Figure 2. That is, Figure 3 shows a portion 300 of a surface layer of a multilayer signal routing device having 952 (i.e., a 28 x 34 array) electrically conductive contacts 302 for mating with 952 (i.e., also a 28 x 34 array) corresponding electrically conductive contacts of a surface mount grid array package of an electronic component that is mounted on the surface of the multilayer signal routing device. Of course, it is within the scope of the present invention that the 952 electrically conductive contacts 302 may mate with 952 corresponding electrically conductive contacts of multiple surface mount grid array packages of multiple electronic components (or multichip modules or hybrid modules having multiple electronic components of like or differing kind) that are mounted on the surface of the multilayer signal routing device.

Figure 3 also shows an electrically conductive contact/via 304 that is electrically connected to each of the electrically conductive contacts 302 on the surface layer of the multilayer signal routing device via a dog-bone configuration. As with Figures 1 and 2, the electrical connections between each of the electrically conductive contacts 302 and each respective electrically conductive contact/via 304 are not shown in Figure 3 for purposes of figure clarity. However, the letter designations associated with each numerical reference designator indicate which electrically conductive contact 302 is electrically connected to which respective electrically conductive contact/via 304. As can be derived from these letter designations, the array of electrically conductive contacts 302, or, more appropriately, the array of electrically conductive contacts/vias 304, may be divided into four main quadrants (e.g., the a, b, c, & d main quadrants). The four main quadrants are separated via the dog-bone configuration by center channels 306, which are formed in the array of electrically conductive contacts 302, or, more appropriately, the array of electrically conductive contacts/vias 304, so as to allow electrical signals to be routed within these center channels 306 in one or more electrically conductive signal path layers of the multilayer signal routing device beneath corresponding ones of the electrically conductive contacts 302. However, in Figure 3, the center channels 306 are expanded from the center of the array of electrically conductive contacts 302 to the outer edges of the array of electrically conductive contacts 302.

Additional channels 308 are again formed in each of the four main quadrants by eliminating rows and columns of electrically conductive contacts 302 in the array of electrically conductive contacts 302, and hence in the array of electrically conductive contacts/vias 304, so as to allow electrical signals to be routed within these additional channels 308 in one or more electrically conductive signal path layers of the multilayer signal routing device beneath corresponding ones of the electrically conductive contacts 302. However, in Figure 3, the additional channels 308 are expanded from the center of the array of electrically conductive contacts 302 to the outer edges of the array of electrically conductive contacts 302.

The expansion of the center channels 306 and the additional channels 308 from the center of the array of electrically conductive contacts 302 to the outer edges of the array of electrically conductive contacts 302 reduces any blocking effects which may be inflicted upon signal paths that are routed on one or more electrically conductive signal path layers of the multilayer signal routing device from the center of the array of electrically conductive contacts 302 by signal paths that are routed on one or more electrically conductive signal path layers of the multilayer signal routing device from the outer edges of the array of electrically conductive contacts 302.

Of course, in order to eliminate rows and columns of electrically conductive contacts 302 in the array of electrically conductive contacts 302, and hence in the array of electrically conductive contacts/vias 304, corresponding rows and columns of electrically conductive contacts must be removed from the surface mount grid array package of the electronic component that is mounted on the surface of the multilayer signal routing device. Thus, one aspect of the present invention is to remove rows and columns of electrically conductive contacts from the surface mount grid array package of the electronic component that is mounted on the surface of the multilayer signal routing device so as to allow corresponding rows and columns of electrically conductive contacts 302 to be removed from the array of electrically conductive contacts 302, and hence the array of electrically conductive contacts/vias 304, thereby allowing additional channels 308 to be formed in the array of electrically conductive contacts 302, or, more appropriately, the array of electrically conductive contacts/vias 304, so as to allow electrical signals to be routed within these additional channels 308 in one or more electrically conductive signal path layers of the multilayer signal routing device beneath corresponding ones of the electrically conductive contacts 302.

Referring to Figure 4, there is shown another exemplary embodiment of the present invention. That is, Figure 4 shows a portion 400 of a surface layer of a multilayer signal routing device having 420 (i.e., 20 x 21 contact cells) electrically conductive contacts 402 for mating with 420 (i.e., also 20 x 21 contact cells) corresponding electrically conductive contacts of a surface mount grid array package of an electronic component that is mounted on the surface of the multilayer signal routing device. Of course, it is within the scope of the present invention that the 402 electrically conductive contacts 402 may mate with 402 corresponding electrically conductive contacts of multiple surface mount grid array packages of multiple electronic components (or multichip modules or hybrid modules having multiple electronic components of like or differing kind) that are mounted on the surface of the multilayer signal routing device.

Figure 4 also shows an electrically conductive contact/via 404 that is electrically connected to each of the electrically conductive contacts 402 on the surface layer of the multilayer signal routing device via a dog-bone configuration. As with Figures 1-3, the electrical connections between each of the electrically conductive contacts 402 and each respective electrically conductive contact/via 404 are not shown in Figure 4 for purposes of figure clarity. However, the letter designations associated with each numerical reference designator indicate which electrically conductive contact 402 is electrically connected to which respective electrically conductive contact/via 404.

While Figure 4 shows the array of electrically conductive contacts 402, and hence the array of electrically conductive contacts/vias 404, as a group of twenty twenty-one contact cells with each cell having a somewhat circular shape, it is within the scope of the present invention to allow any number of cell shapes and sizes (e.g., a square shape). Also, while Figure 4 shows the contact pattern of the array of electrically conductive contacts 402, and hence the array of electrically conductive contacts/vias 404, as being substantially square, it is within the scope of the present invention to allow any number of contact patterns (e.g., a triangular pattern).

Referring to Figure 5, there is shown another exemplary embodiment of the present invention. That is, Figure 5 shows a portion 500 of a surface layer of a multilayer signal routing device having nine subarrays 510 (e.g., each having 1247 contacts) of electrically conductive contacts 502 for mating with nine corresponding subarrays of electrically conductive contacts of a surface mount grid array package of an electronic component that is mounted on the surface of the multilayer signal routing device. Of course, it is within the scope of the present invention that the electrically conductive contacts 502 may mate with corresponding electrically conductive contacts of multiple surface mount grid array packages of multiple electronic components (or multichip modules or hybrid modules having multiple electronic components of like or differing kind) that are mounted on the surface of the multilayer signal routing device.

As shown in Figure 5, the electrically conductive contacts 502 have different shapes corresponding to different electrical properties (e.g., Signal, Ground, Power, and Test electrical properties) associated with the electrically conductive contacts 502. As also shown in Figure 5, each subarray 510 has center channels 506 (light shaded) and additional channels 508 (dark shaded) formed therein. The nine subarrays 510 are sized and spaced so as to allow each subarray 510 to route electrical signals therebetween and within the center channels 506 and additional channels 508 formed therein in one or more electrically conductive signal path layers of the multilayer signal routing device.

Referring to Figures 6A and 6B, there are shown two other exemplary embodiments of the present invention. That is, both Figure 6A and Figure 6B show a portion (600A and 600B, respectively) of a surface layer of a multilayer signal routing device having 330 electrically conductive contacts for mating with 330 corresponding electrically conductive contacts of a quadrant of a surface mount grid array package of an electronic component having a total of 1247 electrically conductive contacts that is mounted on the surface of the multilayer signal routing device. As shown in both Figure 6A and Figure 6B, each of the electrically conductive contacts 602 may have one of several different types of electrical properties (e.g., Signal, Ground (GND), Power (Vdd, Vdd2), or Test). It is preferable to form channels in one or more electrically conductive signal path layers of the multilayer signal routing device beneath electrically conductive contacts 602 that do not have electrical properties associated with Ground (GND) or Power (Vdd, Vdd2), as electrically conductive contacts 602 having Ground (GND) and Power (Vdd, Vdd2) electrical properties typically result in channel blockages (e.g., through hole vias). Thus, as also shown in both Figure 6A and Figure 6B, channels 614 are only proposed to be formed beneath electrically conductive contacts 602 that do not have electrical properties associated with Ground (GND) or Power (Vdd, Vdd2). That is, the channels 614 are only proposed to be formed beneath electrically conductive contacts 602 that have electrical properties associated with Signal or Test, as electrically conductive contacts 602 having Signal or Test electrical properties require only surface signal routing or allow microvias to be utilized as discussed in the above-referenced U.S. Patent Application No. 10/126,700, U.S. Patent Application No. 09/651,188 (now U.S. Patent No. 6,388,890), and U.S. Provisional Patent Application No. 60/212,387, all of which have been incorporated by reference herein in their entirety. Thus, the electronic component that is mounted on the surface of the multilayer signal routing device should be designed with electrically conductive contacts having electrical properties that coincide with that shown in Figures 6A and 6B since such a contact pattern allows the clear orthogonal channels 614 to be formed in electrically conductive signal path layers of the multilayer signal routing device beneath electrically conductive contacts 602 that have electrical properties associated with Signal or Test.

In Figure 6A, the electrically conductive contacts 602 that do not have electrical properties associated with Ground (GND) or Power (Vdd, Vdd2) are only cleared away from locations where channels should be formed. In Figure 6B, the electrically conductive contacts 602 that do not have electrical properties associated with Ground (GND) or Power (Vdd, Vdd2) are cleared away from rows and columns in a reasonably regular pattern that also aligns with where channels need to be formed.

Referring to Figure 7, there is shown is shown another exemplary embodiment of the present invention. That is, Figure 7 shows a portion 700 of a surface layer of a multilayer signal routing device having 952 (i.e., a 28 x 34 array) electrically conductive contacts 702 and 716 for mating with 952 (i.e., also a 28 x 34 array) corresponding electrically conductive contacts of a surface mount grid array package of an electronic component that is mounted on the surface of the multilayer signal routing device. Of course, it is within the scope of the present invention that the 952 electrically conductive contacts 702 and 716 may mate with 952 corresponding electrically conductive contacts of multiple surface mount grid array packages of multiple electronic components (or multichip modules or hybrid modules having multiple electronic components of like or differing kind) that are mounted on the surface of the multilayer signal routing device.

Figure 7 also shows an electrically conductive contact/via 704 that is electrically connected to some of the electrically conductive contacts 702 on the surface layer of the multilayer signal routing device via a dog-bone configuration. As with Figures 1-4, the electrical connections between each of the electrically conductive contacts 702 and each respective electrically conductive contact/via 704 are not shown in Figure 7 for purposes of figure clarity. However, the letter designations associated with each numerical reference designator indicate which electrically conductive contact 702 is electrically connected to which respective electrically conductive contact/via 704. As can be derived from these letter designations, the array of electrically conductive contacts 702 (and 716), or, more appropriately, the array of electrically conductive contacts/vias 704, may be divided into four main quadrants (e.g., the a, b, c, & d main quadrants). The four main quadrants are separated via the dog-bone configuration by center channels 706, which are formed in the array of electrically conductive contacts 702 (and 716), or, more appropriately, the array of electrically conductive contacts/vias 704, so as to allow electrical signals to be routed within these center channels 706 in one or more electrically conductive signal path layers of the multilayer signal routing device beneath corresponding ones of the electrically conductive contacts 702.

As shown in Figure 7, the electrically conductive contacts 716 are not electrically connected to respective ones of the electrically conductive contacts/vias 704. In fact, the electrically conductive contacts 716 are not electrically connected to anything and are commonly referred to as "no-connect" contacts. That is, the electronic component that is mounted on the surface of the multilayer signal routing device is designed with electrically conductive contacts that are not electrically connected to anything and are commonly referred to as "no-connect" contacts. Alternatively, these electrically conductive contacts of the electronic component that coincide with the electrically conductive contacts 716 formed on the surface layer of the multilayer signal routing device may be used only for factory testing electronic component. In either case, these "no-connect" contacts of the electronic component coincide with the electrically conductive contacts 716 formed on the surface layer of the multilayer signal routing device that are not electrically connected to anything. Since these electrically conductive contacts 716 are not connected to anything, additional channels 708 may be formed in electrically conductive signal path layers of the multilayer signal routing device beneath these electrically conductive contacts 716.

At this point it should be noted that the electrically conductive contacts 716 may be removed entirely from the surface layer of the multilayer signal routing device since they are not electrically connected to anything and the additional channels 708 may still be formed in electrically conductive signal path layers of the multilayer signal routing device beneath where these electrically conductive contacts 716 could have been formed.

Referring to Figure 8, there is shown is shown another exemplary embodiment of the present invention. That is, Figure 8 shows a portion 800 of a surface layer of a multilayer signal routing device having 196 (i.e., a 7 x 28 array) electrically conductive contacts 802 and 816 for mating with 196 (i.e., also a 7 x 28 array) corresponding electrically conductive contacts of a surface mount grid array package of an electronic connector component that is mounted on the surface of the multilayer signal routing device. Of course, it is within the scope of the present invention that the 196 electrically conductive contacts 802 and 816 may mate with 196 corresponding electrically conductive contacts of multiple surface mount grid array packages of multiple electronic components (or multichip modules or hybrid modules having multiple electronic components of like or differing kind) that are mounted on the surface of the multilayer signal routing device.

Figure 8 also shows an electrically conductive contact/via 804 that is electrically connected to some of the electrically conductive contacts 802 on the surface layer of the multilayer signal routing device via a dog-bone configuration. As with Figures 1-4, the electrical connections between each of the electrically conductive contacts 802 and each respective electrically conductive contact/via 804 are not shown in Figure 8 for purposes of figure clarity. However, the letter designations associated with each numerical reference designator indicate which electrically conductive contact 802 is electrically connected to which respective electrically conductive contact/via 804. As can be derived from these letter designations, the array of electrically conductive contacts 802 (and 816), or, more appropriately, the array of electrically conductive contacts/vias 804, may be divided into two main halves (e.g., the a and b halves). The two main halves are separated via the dog-bone configuration by a center channel 806, which is formed in the array of electrically conductive contacts 802 (and 816), or, more appropriately, the array of electrically conductive contacts/vias 804, so as to allow electrical signals to be routed within this center channel 806 in one or more electrically conductive signal path layers of the multilayer signal routing device beneath corresponding ones of the electrically conductive contacts 802.

As shown in Figure 8, the electrically conductive contacts 816 are not electrically connected to respective ones of the electrically conductive contacts/vias 804. In fact, the electrically conductive contacts 816 are not electrically connected to anything and are commonly referred to as "no-connect" contacts. That is, the electronic connector component that is mounted on the surface of the multilayer signal routing device is provided with electrically conductive contacts that are not electrically connected to anything and are commonly referred to as "no-connect" contacts. These "no-connect" contacts of the electronic connector component coincide with the electrically conductive contacts 816 formed on the surface layer of the multilayer signal routing device that are not electrically connected to anything. Since these electrically conductive contacts 816 are not connected to anything, additional channels 808 may be formed in electrically conductive signal path layers of the multilayer signal routing device beneath these electrically conductive contacts 816.

At this point it should be noted that the electrically conductive contacts 816 may be removed entirely from the surface layer of the multilayer signal routing device since they are not electrically connected to anything and the additional channels 808 may still be formed in electrically conductive signal path layers of the multilayer signal routing device beneath where these electrically conductive contacts 816 could have been formed.

The present invention is not to be limited in scope by the specific embodiments described herein. Indeed, various modifications of the present invention, in addition to those described herein, will be apparent to those of ordinary skill in the art from the foregoing description and accompanying drawings. Thus, such modifications are intended to fall within the scope of the following appended claims. Further, although the present invention has been described herein in the context of a particular implementation in a particular environment for a particular purpose, those of ordinary skill in the art will recognize that its usefulness is not limited thereto and that the present invention can be beneficially implemented in any number of environments for any number of purposes. Accordingly, the claims set forth below should be construed in view of the full breath and spirit of the present invention as disclosed herein.

## Claims

1. An interconnect array for electrically interconnecting electrical signals between an electronic component and a multilayer signal routing device having a plurality of electrically conductive signal path layers, the interconnect array comprising:
a plurality of electrically conductive contacts grouped into a plurality of arrangements of electrically conductive contacts, each of the plurality of arrangements of electrically conductive contacts being separated from other adjacent ones of the plurality of arrangements of electrically conductive contacts by a channel that is correspondingly formed in the multilayer signal routing device such that an increased number of electrical signals may be routed therein on the plurality of electrically conductive signal path layers.

2. The interconnect array of claim 1, wherein each of the plurality of arrangements of electrically conductive contacts may have any number of shapes and sizes.

3. The interconnect array of claim 1, wherein the channel is formed by removing electrically conductive contacts from a non-channelized interconnect array.

4. The interconnect array of claim 3, wherein the electrically conductive contacts that are removed from the non-channelized interconnect array comprise at least one of a row of electrically conductive contacts and a column of electrically conductive contacts.

5. The interconnect array of claim 1, wherein the plurality of electrically conductive contacts that are grouped into the plurality of arrangements of electrically conductive contacts has a substantial center and at least one substantial edge, and wherein the channel expands in width while traversing from the substantial center to the at least one substantial edge.

6. The interconnect array of claim 1, wherein all of the plurality of arrangements of electrically conductive contacts are associated with a single electronic component.

7. The interconnect array of claim 1, wherein at least one of the plurality of arrangements of electrically conductive contacts is associated with a separate electronic component.

8. The interconnect array of claim 1, wherein each of the plurality of electrically conductive contacts has an associated electrical property, and wherein at least some of the plurality of electrically conductive contacts are physically arranged based at least in part upon their associated electrical properties such that the channel is formed in accordance with the arrangement.

9. The interconnect array of claim 8, wherein the electrical property associated with each of the plurality of electrically conductive contacts comprises one of a signal electrical property, a power electrical property, a ground electrical property, a test electrical property, and a no-connect electrical property.

10. The interconnect array of claim 1, wherein the channel coincides with selected ones of the plurality of electrically conductive contacts.

11. The interconnect array of claim 1, wherein the channel that is correspondingly formed in the multilayer signal routing device is formed on at least one of the plurality of electrically conductive signal path layers beneath selected ones of the plurality of electrically conductive contacts.

12. A method for electrically interconnecting electrical signals between an electronic component and a multilayer signal routing device having a plurality of electrically conductive signal path layers, the method comprising:
identifying a plurality of electrical signals to be routed; and
arranging a plurality of electrically conductive contacts each associated with respective ones of the plurality of electrical signals into a plurality of arrangements of electrically conductive contacts, each of the plurality of arrangements of electrically conductive contacts being separated from other adjacent ones of the plurality of arrangements of electrically conductive contacts by a channel that is correspondingly formed in the multilayer signal routing device such that an increased number of the plurality of electrical signals may be routed therein on the plurality of electrically conductive signal path layers.
